# EUROPEAN PATENT SPECIFICATION

(11) **EP 4 078 689 B1**
(45) Date of publication and mention of the grant of the patent: **13.03.2024**
(21) Application number: 20820133.5
(22) Date of filing: 04.12.2020
(51) Int. Cl.: H01L 31/068, H01L 31/18

(54) **METHOD AND WET BENCH FOR SELECTIVELY REMOVING AN EMITTER LAYER ON A SINGLE SIDE OF A SILICON SUBSTRATE**
VERFAHREN UND NASSBANK ZUM SELEKTIVEN ENTFERNEN EINER EMITTERSCHICHT AUF EINER EINZIGEN SEITE EINES SILIZIUMSUBSTRATS
PROCÉDÉ ET BANC HUMIDE POUR RETIRER SÉLECTIVEMENT UNE COUCHE D'ÉMETTEUR SUR UN SEUL CÔTÉ D'UN SUBSTRAT DE SILICIUM

(30) Priority: 20.12.2019 GB 201919018
(43) Date of publication of application: 26.10.2022
(73) Proprietor: Singulus Technologies AG, 63796 Kahl am Main (DE)
(72) Inventor: JACOBI, Jan-Christof, 35232 Dautphetal (DE); KILIN, Eduard, 81543 München (DE); MANDLMEIER, Benjamin, 82343 Pöcking (DE); WATTENBERG, Bianca, 82239 Alling (DE); REUSTLE, Peter, 74399 Walheim (DE); NOACK, Philipp, 82216 Maisach (DE)
(74) Representative: Qip Patentanwälte Dr. Kuehn & Partner mbB
(86) International application number: PCT/EP2020/084708
(87) International publication number: WO 2021/122068

(56) References cited:
- EP-A2- 2 466 650
- CN-A- 105 322 047
- DE-A1-102011 056 495
- US-A1- 2015 011 036
- US-A1- 2015 372 184

## Description

### FIELD OF THE INVENTION

The present invention relates to a method for selectively removing an emitter layer on a single side of a silicon substrate. Furthermore, the present invention relates to a wet bench configured for implementing the proposed method.

### BACKGROUND OF THE INVENTION

In semiconductor devices, there are generally doped layers or areas at a surface of a semiconductor substrate, wherein the layers have a doping of a type opposite to a doping type of a base of the semiconductor substrate. Such layers are often referred to as emitter layers.

For example, in solar cells, emitter layers are provided for generating a pn junction at which excess minority charge carriers generated upon light absorption may be locally separated.

Many semiconductor devices are manufactured using a silicon substrate. Particularly, most of today's solar cells are produced based on silicon substrates. Such silicon substrates may be mono-crystalline or multi-crystalline silicon wafers.

In manufacturing semiconductor substrates, particularly in manufacturing silicon solar cells, there may be a requirement of selectively removing an emitter layer which has previously be formed in preceding manufacturing steps. Particularly, the preceding manufacturing steps such as an emitter diffusion step may result in an emitter layer being formed not only in areas where the emitter layer is required in the final manufactured product but also in other areas. Accordingly, parts of the emitter layer may have to be selectively locally removed.

Furthermore, in generating the emitter layer, manufacturing methods and techniques may be applied which not only result in the emitter layer being formed but which also result in an additional silicate glass layer being formed on top of the emitter layer. For example, upon forming an emitter layer using phosphorus or boron diffusion, a phosphorous silicate glass (PSG) layer or a boron silicate glass (BSG) layer is typically formed on top of the emitter layer formed by diffusion of phosphorous or boron, respectively, into a superficial region of the silicon substrate.

Accordingly, in semiconductor device manufacturing and particularly in silicon solar cell manufacturing, requirements may occur where, as a result of preceding manufacturing steps, an emitter layer being covered with a silicate glass layer is provided at both of opposing sides of a silicon substrate and the emitter layer then has to be removed from a single side of the silicon substrate.

Conventionally, processing steps have been applied to fulfil such requirements, in which processing steps only the side at which the emitter layer has to be removed was brought into contact with an etching solution. The etching solution was such that both, the covering silicate glass layer as well as the emitter layer at the surface of the silicon substrate where etched-back using the etching solution in a single etch step. In order to be able to etch both, the silicate of the glass layer as well as the doped silicon of the emitter layer, an etching solution was applied which comprised both, hydrofluoric acid (HF) as well as an oxidising chemical such as nitric acid (HNO₃). Therein, the hydrofluoric acid efficiently etches phosphorous silicate or boron silicate as well as silicon oxides. The nitric acid oxidises the silicon of the emitter layer in order to form silicon oxides which may then be etched by the hydrofluoric acid. Accordingly the silicate glass layer and the underlying emitter layer may be etched in a single common etching step. EP2466650A2 discloses a conventional method of selectively removing an emitter layer.

However, as described further below, the conventional approach may have disadvantages.

### SUMMARY OF THE INVENTION AND OF EMBODIMENTS

There may be a need for an alternative method for selectively removing an emitter layer on a single side of a silicon substrate. Particularly, there may be a need for such method which enables local emitter removal with improved characteristics resulting for the final semiconductor device, which enables using less harmful etching solutions and/or which enables simplifying a local emitter removal procedure and/or rendering the procedure more cost efficient. Furthermore, there may be a need for a method for fabricating a silicon solar cell using the proposed method. Finally, there may be a need for a device configured for implementing such method.

Such needs may be met with the subject matter of the independent claims. Advantageous embodiments are described in the dependent claims as well as in the following specification.

According to a first aspect of the invention, a method for selectively removing an emitter layer on a single side of a silicon substrate is described. Therein, the silicon substrate initially comprises an emitter layer at both opposing sides and wherein the silicon substrate initially comprises a silicate glass layer covering the emitter layer at both opposing sides. The proposed method comprises at least the following steps, preferably in the indicated order:
- selectively removing the silicate glass layer exclusively on a first side of a silicon substrate by contacting the silicate glass layer exclusively on the first side with a first etching solution, the first etching solution etching silicate glass and not substantially etching silicon; and
- removing the emitter layer on the first side of a silicon substrate by contacting the emitter layer on the first side with a second etching solution, the second etching solution etching silicon and not substantially etching silicate glass.

According to a second aspect of the invention, a method for fabricating a silicon solar cell is proposed, the method comprising
(i) generating a doped emitter layer in a silicon substrate and a silicate glass layer covering the emitter layer, the emitter layer and the silicate glass layer being generated by diffusing dopants from an atmosphere comprising the dopants and further comprising oxygen into a surface area at both sides of the silicon substrate;
(ii) selectively removing the emitter layer on a single side of the silicon substrate using the method according to an embodiment of the first aspect of the invention.

According to a third aspect of the invention, a wet bench is described, the wet bench being configured for implementing an embodiment of the method according to the first aspect of the invention.

Particularly, such wet bench may comprise a first etchant applicator, a second etchant applicator and a transportation mechanism. The first etchant applicator is configured for accommodating a first etching solution and applying the first etching solution to a silicon substrate, the first etching solution etching silicate glass and not substantially etching silicon. The second etchant applicator is configured for accommodating a second etching solution and applying the second etching solution to the silicon substrate, the second etching solution not substantially etching silicate glass but etching silicon. The transportation mechanism is configured for transporting multiple silicon substrates along a transportation path ranging initially from an entry area to the first etchant applicator, then to the second etchant applicator and finally to an exit area.

Therein, each of the first and second etchant applicator and the transportation mechanism is configured such that the first and second etching solution, respectively, is applied exclusively to a first side of the silicon substrate.

Ideas underlying embodiments of the present invention may be interpreted as being based, inter alia and without restricting a scope of the invention, on the following observations and recognitions.

Embodiments and characteristics of the method and the device proposed herein will be described in the following mainly with reference to producing wafer-based silicon solar cells. However, it is to be noted that the method and device may also be applied in producing other semiconductor devices based on silicon substrates or other semiconductor substrates.

Generally, a silicon wafer has a thickness of less than 1 mm, typically between 100 µm and 400 µm, while having lateral dimensions of many square centimetres, typically between 5 × 5 cm² and 30 × 30 cm². As such, the silicon wafer may be interpreted as being quasi-2-dimensional. Accordingly, the silicon wafer has two opposing sides or surfaces, i.e., for a vertical wafer, an upper side and a lower side. Surfaces connecting the upper side with the lower side shall not be referred to herein as forming sides but as forming flanks or edges. A flank or edge may be attributed to one of the sides. Particularly, in the context described herein, all flanks or edges or at least parts thereof may be attributed to the first side of the silicon substrate, i.e. to the side from which the emitter shall be removed.

Most of today's industrially produced solar cells are fabricated using a silicon wafer with a p-type or n-type base doping in which an emitter layer of opposite doping is generated. In many cases, the emitter layer is generated by applying a high-temperature diffusion step in which dopants of the opposite type are comprised in a high-temperature gas atmosphere, for example in a tube furnace, and are therefore diffused into superficial regions of silicon wafers introduced into this atmosphere. For example, a silicon wafer having a p-type base doping may be provided with a n-type emitter by diffusing phosphorus from a high-temperature atmosphere containing POCl₃.

While such emitter generation allows a high throughput and a high reliability, the diffused emitter layer extends along the entire outer surface of the silicon wafer, i.e. the emitter layer is generated at both sides of the silicon wafer. Furthermore, as the high-temperature atmosphere used during emitter diffusion generally also contains oxygen, a doped silicate glass layer is generally formed on top of the emitter layer as a result of the emitter diffusion procedure. For example, a phosphorous-doped silicate glass (PSG) layer generally covers an n-type emitter produced in a POCl₃-containing atmosphere. Similarly, a boron-doped silicate glass (BSG) layer generally covers a p-type emitter produced in a boron-containing atmosphere.

In most-applied industrially-produced silicon solar cell concepts, an emitter layer extends along a front side of the silicon wafer and is to be electrically contacted there by emitter contacts, whereas the base of the silicon wafer is to be electrically contacted by base contacts provided at a rear side of the silicon wafer. This is for example the case in a conventional BSF (back surface field) solar cell concept as well as in a modern PERC (passivated emitter and rear cell, sometimes also referred to as passivated emitter and rear contact) solar cell concept. In such concepts, the front side and the rear side of the silicon wafer have to be electrically isolated from each other. Particularly, short-circuits between the base contacts, on the one hand, and the emitter layer or the emitter contacts, on the other hand, shall be avoided.

For such purpose, the emitter layer previously generated at both sides of the silicon wafer has to be removed from one side, for example from the rear side, of the silicon wafer. Furthermore, in most solar cell concepts, the emitter additionally has to be removed from the flanks or edges of the silicon wafer, in order to avoid for example short-circuits between rear contacts contacting the rear side of the silicon solar cell as well as its flanks or edges. Accordingly, the term "removing an emitter layer on a single side of a silicon substrate" shall be interpreted herein in a broad manner and may include removing the emitter layer at the flanks or edges of the silicon substrate. Such single-sided removal of the emitter layer is sometimes also referred to as "edge isolation".

As briefly described in the above introductory portion, in conventional approaches for the edge isolation, an etching solution has been applied to the rear side of the silicon substrate. Therein, the etching solution comprised both, hydrofluoric acid for etching silicon oxides and silicates glasses as well as nitric acid as an oxidising chemical for insitu oxidising silicon and subsequently etching of the silicon oxide by the hydrofluoric acid. Accordingly, both, the doped silicon forming the emitter layer as well as the doped silicate glass layer covering the emitter layer where removed in a single etching step.

However, it has been observed that handling the combined etching solution comprising hydrofluoric acid and nitric acid may result in various problems. For example, both, hydrofluoric acid as well as nitric acid are very dangerous and toxic such that a high level of security measures has to be taken in industrial solar cell production upon applying the combination of these acids. Furthermore, particularly upon applying nitric acid, reaction products including nitrogen-containing chemical compositions, such as nitrous fumes or nitrogen oxides (NOₓ), e.g. nitrogen dioxide (NO₂), generally occur. Such reaction products may be harmful such that substantial safety requirements may have to be fulfilled upon their disposal. Accordingly, in the conventional approach applying a single etching step with a combined etching solution, substantive efforts have to be made and costs are to be paid for securely providing and disposing the etching solution and its reaction products.

Furthermore, it has been observed that upon applying the conventional single etching step, the side of the silicon substrate from which the emitter had been etched away frequently showed a relatively uneven surface. Such surface may comprise small craters or similar recessing or protruding structures. Such uneven surface may result in technical problems in further handling and/or processing the silicon substrate in subsequent processing steps. Alternatively or additionally, such uneven surface may result in disadvantages for the final solar cell.

In order to overcome at least some of the described problems and disadvantages, the method proposed herein replaces the conventional single etching step by a two-step etching procedure.

Therein, in a first step, a first etching solution is applied. The first etching solution is selected such that it etches silicate glass but does not substantially etch silicon. "Not substantially etch" may be interpreted in this context in that an etching rate with regard to silicon is at least three times, preferably at least 10 times or even more than 100 times, smaller than an etching rate with regard to silicate glass. Therein, the first etching solution is applied exclusively to the first side of the silicon substrate. Accordingly, the silicate glass layer previously generated at this first side on top of the emitter layer is locally removed due to the etching action of the first etching solution.

The wet bench proposed for implementing the method proposed herein may comprise a first etchant applicator. This first etchant applicator may accommodate the first etching solution and apply it to the silicon substrate. Therein, the first etchant applicator is configured for handling and applying the first etching solution. This means, inter alia, that the first etchant applicator comprises components which, when coming into contact with the first etching solution, may resists this first etching solution over long terms. For example, materials used in the first etchant applicator may be adapted for resisting the first etching solution. Furthermore, the first etchant applicator may comprise a reservoir in which the first etching solution may be accommodated and some fluid communication lines through which the first etching solution may be transmitted for finally applying it to the silicon substrate. Furthermore, the first etchant applicator may comprise safety components for fulfilling safety requirements upon handling the first etching solution. For example, the first etchant applicator may comprise ventilation means or suction means for removing any harmful moistures, gases or reaction products generated upon applying the first etching solution to the silicon substrate.

Preferably, the first etching solution is free from any oxidising chemicals. Therein, oxidising chemicals may also referred to as oxidising agents and have chemical characteristics in that they oxidise silicon upon contacting its surface. In being free from oxidising chemicals, the first etching solution selectively only etches the silicate glass layer which had already been produced in preceding processing steps but does not generate any additional silicon oxides during the etching procedure. Accordingly, the first etching solution may have a high degree of etching selectivity in that it exclusively etches the silicate glass layer but does not attack the silicon emitter layer underneath this glass layer.

Particularly, preferably, the first etching solution is free from nitric acid (HNO₃). By excluding nitric acid, the first etching solution generally does not generate any reaction products including nitrogen-containing chemical compositions. Therefore, disposal of reaction products may be easier.

Preferably, the first etching solution comprises hydrofluoric acid (HF). Particularly, the first etching solution may be pure in a sense that it only comprises HF and water. For example, the hydrofluoric acid may be provided with a concentration in a range of between 0.1 wt% and 20 wt% or between 0.1 wt% and 15 wt%, preferably between 5 wt% and 10 wt%. Preferably, any further chemical components or contaminations shall provide less than 5 vol-%, preferably less than 1 vol-% to the first etching solution. Hydrofluoric acid selectively etches silicon dioxide but does not substantially etch silicon. In the two-step approach described herein, lower HF-concentrations may be applicable than in conventional etching procedure typically applying high HF+HNO₃-concentrations.

Subsequent to the first etching step, a second etching step is applied. In this second etching step, a second etching solution is applied to the emitter layer which, in the preceding first etching step, has been freed from the covering silicate glass layer and is therefore locally exposed. Therein, the second etching solution is selected and composed such that it etches silicon but does not substantially etch silicate glass. In other words, the etching selectivity of the second etching solution is opposite to the etching selectivity of the first etching solution. Accordingly, while the second etching solution may attack and remove the doped silicon forming the emitter layer exposed at the first side of the silicon substrate, it may not substantially attack and remove the silicate glass layer still covering the emitter layer at the second side of the silicon substrate. In cases in which the second etching solution shows a substantially slower but non-zero etching rate for silicate glass as compared to the etching rate for silicon, etching durations may have to be specifically adapted such as to avoid that the silicate glass layer on the second side is completely etched back during the second etching step and may then no more protect the underlying emitter layer.

The wet bench proposed for implementing the method proposed herein comprises a second etchant applicator. The second etchant applicator may accommodate the second etching solution and apply it to the silicon substrate. The second etchant applicator may be configured for handling and applying the second etching solution by comprising suitable components, materials, etc. such as explained similarly above with respect to the first etchant applicator.

Preferably, the second etching solution is an alkaline base. In other words, the second etching solution has a pH value of significantly higher than 7.0, preferably higher than 9.0 or even higher than 12.0. Using an alkaline base as second etching solution may result in various benefits. For example, such alkaline base may be handled with less strict safety requirements to be fulfilled. Furthermore, alkaline bases may be provided at relatively low costs and may be handled with relatively cheap equipment. Additionally, alkaline bases and their reaction products may be disposed with less strict requirements to be fulfilled. Furthermore, no nitrous gases or fumes are generated which, otherwise, could attack the exposed emitter layer at the opposite side of the silicon substrate.

For example, the second etching solution may comprise as alkaline base potassium hydroxide (KOH), sodium hydroxide (NaOH) or tetramethylammonium hydroxide (TMAH). Such alkaline bases may provide for, inter alia, the above-mentioned benefits.

Preferably, the second etching solution may comprise between 0.1 wt% and 60 wt%, more preferably between 1 wt% und 30 wt%, of the alkaline base. Such concentrations in the second etching solution have shown beneficial etching results upon removing the emitter layer. Particularly, such concentrations allow for a sufficiently fast and reliable emitter layer removal.

Furthermore, the second etching solution may be applied with a temperature of between 20°C and 160°C, preferably between 50°C and 120°C and more preferably between 80°C and 100°C. Such temperatures of the second etching solution have shown beneficial etching results upon removing the emitter layer. Generally, the higher the temperature of the second etching solution, the higher is its etching rate. The indicated temperature ranges provide a good compromise between sufficiently rapid etching, on the one hand, and reliably removing the entire emitter layer as well as avoiding excessively back-etching the silicon substrate, on the other hand.

The wet bench proposed for implementing the method proposed herein and particularly its second etchant applicator may be provided with a heater for applying the second etching solution with an elevated temperature. For example, the heater may heat the second etching solution accommodated in a reservoir and/or upon applying the second etching solution to the silicon substrate. The heater may be an electric heater. A heating action of the heater may be controlled by a controller. Furthermore, the second etchant applicator may comprise temperature measurement means for measuring the actual temperature of the second etching solution.

As a further option, the second etching solution may initially be applied with a low temperature of between 0°C and 60°C, preferably between 10°C and 40°C or between 15°C and 30°C, onto the first side of the silicon substrate and may subsequently be heated to an elevated temperature of between 40°C and 160°C, preferably between 60°C and 120°C and more preferably between 80°C and 100°C. Accordingly, upon initially applying the second etching solution, it has a very low etching activity due to its low temperature, but reaches a substantially higher etching activity upon being heated to the elevated temperature.

According to an embodiment, the second etching solution may comprise an additive. The additive may influence or change characteristics, particularly chemical characteristics, of the second etching solution.

Particularly, the additive may be selected such that it increases a selectivity of an etching action of the second etching solution with respect to etching silicon compared to etching silicate glass. In other words, by adding the additive to the second etching solution, its characteristics to selectively etching silicon but not etching silicate glass may be further improved. Organic additives comprising some carbon-content appear to be promising for such purpose.

Preferably, the second etching solution may comprise between 0.1 % and 30 %, more preferably between 0.1 % and 10 %, of the additive. Such concentrations of additive in the second etching solution have shown to be beneficial for the entire etching action.

According to an embodiment, the first etching solution is applied to the silicate glass layer on the first side by contacting the first side with a roller and transmitting the first etching solution through a skin surface of the roller.

For implementing such method step, the first etchant applicator may be provided with at least one roller having openings at a skin surface of the roller and the first applicator may be configured for applying the first etching solution to the first side of the silicon substrate by conveying the first etching solution through the openings at the skin surface of the roller while the silicon substrate being with its first side adjacent to the skin surface of the roller.

In other words, the first etchant applicator of the wet bench proposed herein may comprise one or several rollers. These rollers may be part of the transportation mechanism for transporting the silicon substrates to the first etchant applicator and from the first etchant applicator to the second etchant applicator. Alternatively, the rollers may be separate from such transportation mechanism. The rollers may have a porous skin surface. Such porous skin surface may comprise multiple openings through which the first etching solution may be transferred from inside the roller to an outside surface of the roller. Accordingly, the first etching solution may be transferred from the roller to the first side of the silicon substrate by contacting the silicon substrate with the skin surface of the roller and simultaneously ejecting some first etching solution through this porous skin surface. Thereby, the first etching solution may be applied exclusively to the first side of the silicon substrate. Details of a device and method for treating substrates using a support roller having a porous material are given for example in

WO 2017/216350 A1 filed by the applicant of the present invention.

Alternatively, the first etching solution may be applied to the silicate glass layer on the first side by selectively contacting a fluid reservoir comprising the first etching solution exclusively with the first side of the silicon substrate. For example, a meniscus comprising the first etching solution may be wetting the first side of the silicon substrate. An apparatus and method for treating plate-shaped process items is described in WO 2013/110582 A1 and provides possible details of such etching solution application.

According to an embodiment, subsequent to removing the silicate glass layer at the first side of the silicon substrate, the then exposed emitter layer on the first side of the silicon substrate may be contacted with the second etching solution by completely immersing the silicon substrate into the second etching solution.

In other words, the silicon substrate may be dipped into the second etching solution such that the second etching solution covers the silicon substrate at both of its opposing sides. However, as the silicate glass layer has been removed in the preceding first etching step only at the first side of the silicon substrate, the second side of the silicon substrate is still covered with a silicate glass layer. This silicate glass layer may protect the underlying silicon and the emitter comprised therein at the second side of the silicon substrate against the attacking second etching solution. Expressed differently, the silicate glass layer may act as a protection layer preventing the second etching solution to contact the silicon substrate and the emitter at its second side. Therefore, the second etching solution reacts only with the first side.

Accordingly, upon immersing the silicon substrates into the second etching solution, the emitter layer exposed at the first side of the silicon substrate is removed by the etching action of the second etching solution whereas the emitter layer at the second side of the silicon substrate remains unetched. This is true as long as the silicate glass layer is sufficiently tight for protecting this second side.

However, it has been observed that sometimes, the silicate glass layer at the second side of the silicon substrate may not serve as an effective protection layer. For example, in some specific solar cell concepts, the silicate glass layer may be damaged or modified in its physical or chemical characteristics prior to being subject to the method proposed herein. This is e.g. the case in a so-called LD-SE-PERC solar cell concept (laser diffused selective emitter passivated emitter and rear cell), in which applying a laser beam onto the doped silicate glass layer is used for locally additionally doping the underlying emitter layer. Upon absorption of the laser beam, the silicate glass layer may be modified and lose its capacity as forming an effective etching protection layer.

In such conditions, it may be beneficial to adapt the proposed method and/or establish specific structural or functional features in the proposed wet bench such as to ensure that the second etching solution is applied exclusively to the first side of the silicon substrate but is prevented from reaching the second side of the silicon substrate.

For example, it may be beneficial to contact the emitter layer on the first side of the silicon substrate with the second etching solution by spraying the second etching solution onto the emitter layer on the first side of the silicon substrate.

For such purpose, the second etchant applicator of the wet bench proposed herein may be provided with a sprayer for spraying the second etching solution onto the first side of the silicon substrate.

In other words, instead of immersing the entire silicon substrate into the second etching solution, this solution may be sprayed selectively only onto the first side of the silicon substrate, where its emitter layer has been previously exposed by removing the covering silicate glass layer. Upon such spraying, no substantial volumes of second etching solution may reach the opposite second side of the silicon substrate. Accordingly, even in cases where the silicate glass layer remaining on such second side is not completely tight and may therefore not provide for reliable etching protection, no substantive etching action is induced on the second side of the silicon substrate but only the emitter layer at the first side is removed.

It may be noted that, generally, some moisture may evaporate from the second etching solution at the first side of the silicon substrate and may reach the second side of the silicon substrate. However, as such moisture generally does not have a same etching capacity as the liquid second etching solution, even a damaged or modified silicate glass layer on the second side may sufficiently act as protection layer against any attack of such moisture. Similarly, for example adhesion forces or capillary forces may result in some of the second etching solution being drawn from the first side to the second side of the silicon substrate. However, as the volume of second etching solution reaching the second side of the silicon substrate in such manner is generally very small, the silicate glass layer may still sufficiently protect the emitter layer at such second side.

For spraying the second etching solution onto the silicon substrate, the second etchant applicator may comprise one or plural sprayers such as nozzles or other spraying means. The nozzles may have different shapes and/or may be of different types.

Preferably, the second etching solution may be sprayed from underneath the silicon substrate towards the first side of the silicon substrate being directed downwards.

For such purpose, the sprayer of the second etchant applicator may be arranged underneath the transportation path and the sprayer may be configured for spraying the second etching solution in an upwards direction onto the first side of the silicon substrate.

By arranging the silicon substrate with its first side being directed downwards and then spraying the second etching solution in an upwards direction onto this first side, selectivity of the etching procedure may be improved. Upon impacting onto the lower surface of the silicon substrate, a liquid film of second etching solution may cover this surface on the first side of the silicon substrate but may not significantly "climb" upwards to the opposing second side of the silicon substrate. Instead, the second etching solution will drop down from the first side after a while and may then be collected and possibly reused.

According to a specific embodiment, the second etching solution may be applied onto the emitter layer on the first side of the silicon substrate with the second etching solution having a first temperature. Therein, upon applying the second etching solution onto the emitter layer on the first side of the silicon substrate, a cooling solution is applied onto the second side of the silicon substrate, the cooling solution having a second temperature being lower than the first temperature.

Expressed differently, together with providing the second etching solution with an elevated first temperature of for example between 80°C and 100°C and applying the second etching solution onto the first side of the silicon substrate, another solution may be applied to the silicon substrate on its opposite second side. This solution may be substantially cooler than the second etching solution and is therefore referred to as cooling solution. In other words, while the second etching solution heats the silicon substrate at its first side, the cooling solution cools the same silicon substrate at its opposing second side.

Accordingly, the hot second etching solution may effectively etch-back the emitter layer at the first side. However, in case some portion of the second etching solution or some moisture evaporating from such hot second etching solution may reach the second side of the silicon substrate, it is substantially cooled down by the cooling solution and may therefore not generate significant etching action at this second side.

Accordingly, even in cases where for example the silicate glass layer at the second side does not provide sufficient etching protection for the underlying emitter layer, attacking this emitter layer is reliably prevented as any second etching solution reaching this second side is substantially cooled down by the cooling solution and may therefore no more significantly etch the emitter layer at this second side.

The cooling solution may be applied to the silicon substrate simultaneously or shortly before or shortly after the second etching solution is applied to the silicon substrate. Furthermore, the cooling solution may be applied at a corresponding location to where the second etching solution is applied to the silicon substrate.

For such purpose, the wet bench proposed herein may further comprise a coolant applicator for accommodating the cooling solution and applying the cooling solution to a second side of the silicon substrate. Therein, the coolant applicator and the second etchant applicator are arranged and configured such that the cooling solution is applied to the second side of the silicon substrate before or upon applying the second etching solution to the first side of the silicon substrate and the cooling solution has a second temperature being lower than a first temperature of the second etching solution.

For example, the coolant applicator may be another sprayer through which the cooling solution may be sprayed onto the silicon substrate. Alternatively, a dispenser, a spraybar or an applicator generating some "soft raining" may be applied. With reference to the transportation path and to a silicon substrates transported along this transportation path, the sprayer spraying the second etching solution and the sprayer spraying the cooling solution may be arranged at opposite sides and spray their solutions to opposite surfaces of the silicon substrate. Preferably, the sprayer spraying the second etching solution is arranged underneath the transportation path whereas the sprayer spraying the coolant solution is arranged above the transportation path. Accordingly, the hot second etching solution reaches the first side of the silicon substrate while its opposite second side is cooled by the cooling solution.

Preferably, the second temperature may be at least 20K, more preferably at least 30K or at least 40K, lower than the first temperature. Accordingly, the cooling solution may significantly cool the silicon substrate on its second side upon hot second etching solution reaching and etching its first side.

Preferably, the cooling solution may be an etching solution. Particularly, the cooling solution may have a same chemical composition as the second etching solution. In other words, while, in principle, the cooling solution may be any kind of liquid, it may be preferable that the cooling solution has etching capacity and, particularly, has the same chemical composition and characteristics as the second etching solution. Particularly, it may be preferable that the cooling solution has the same chemistry and concentration as the second etching solution and differs from the second etching solution only with respect to its temperature upon being applied to the silicon substrate.

In principle, such cooling solution may therefore also etch the second side of the silicon substrate. However, as an etching rate generally strongly depends on the temperature of the etching solution, the cooling solution will provide for a significantly lower etching rate at the second side of the silicon substrate than the hot second etching solution will provide at the first side of the silicon substrate.

Due to having the same chemical composition, also a mixture of the second etching solution and the cooling solution has the same chemical composition as the second etching solution itself. Benefit may be taken from this characteristics in that, for example, the cooling solution may be sprayed on top of the silicon substrate and may then mix with the second etching solution upon dropping down from the second side of the silicon substrate and being collected together with the second etching solution dropping down from the first side of the silicon substrate. The mixture of both solutions has a same chemical composition and preferably also a same concentration as each of the second etching solution and the cooling solution. Accordingly, the mixture may be easily reused or redistributed by for example heating it to the first temperature and spraying it again onto the first side or heating it only to the lower second temperature and spraying it again onto the second side of the silicon substrate.

Alternatively, the cooling solution may be no etching solution. For example, the cooling solution may be water or another solvent. Particularly, the cooling solution may be the solvent used for the second etching solution.

In the following, embodiments of another approach for a specific implementation of the proposed method and/or of specific structural or functional features in the proposed wet bench will follow. Similar to the approach described above, such approach shall ensure that the second etching solution is applied exclusively to the first side of the silicon substrate but is prevented from reaching the second side of the silicon substrate.

In such approach, in the step of removing the emitter layer, the silicon substrate is arranged with its first side directed in an upwards direction. Therein, the second etching solution is applied on top of the first side of the silicon substrate and a non-etching liquid is brought into contact with the second side of the silicon substrate.

In other words, in such approach, the emitter layer shall be removed from the first side in the second etching step with this first side being arranged at an upper side of the silicon substrate. As the first side of the silicon substrate is typically a rear side of a resulting solar cell and such rear side is opposite to a front side to be directed towards the sun and therefore sometimes referred to as "sunny side", such arrangement of the silicon substrate may also be referred to as "sunny side down" configuration.

In such sunny side down configuration, the second etching solution may be applied to the first side of the silicon substrate using gravity, i.e. the second etching solution may for example be dropped, flushed, dispensed or sprayed from a position further upwards to the silicon substrate in a direction downwards to the upper side of the silicon substrate, this upper side being the first side of the silicon substrate. Accordingly, the second etching solution may accumulate on the first side and then etch this first side of the silicon substrate in order to remove the emitter layer which is exposed at this first side due to the preceding removing of the glass layer originally covering the emitter layer.

However, there may be a risk that parts of the second etching solution may e.g. flow around edges of the silicon substrate, thereby reaching the second side of the silicon substrate. In order to prevent such situation, this second, "sunny side" of the silicon substrate shall be protected against being attacked by second etching solution by bringing this second side into contact with a non-etching liquid. Generally, the non-etching liquid contacting the second side of the silicon substrate prevents the second etching solution contacting the upper first side of the silicon substrate from flowing around edges of the silicon substrate and reaching the lower second side of the silicon substrate.

Such non-etching liquid may be any liquid which does not substantially attack and etch the exposed emitter layer of the silicon substrate and/or the glass layer covering the emitter layer. Generally, the non-etching liquid may have an etching rate with regard to the exposed emitter layer of the silicon substrate which is at least one order of magnitude smaller than an etching rate of the second etching solution with regard to the same emitter layer under the same environmental conditions. Accordingly, the non-etching liquid or at least a major portion of this non-etching liquid differs in its chemical composition from the second etching solution. For example, such non-etching liquid may be water or a water-based solution. Particularly, the non-etching liquid may be purified water or deionised water.

The wet bench proposed herein may be adapted for implementing such approach.

For example, the second etchant applicator in such wet bench may comprise a dispenser, a flusher, a dripper and/or a sprayer configured for applying the second etching solution on top of the first side of the silicon substrate upon the silicon substrate being arranged with its first side directed in an upwards direction. The dispenser, flusher, a dripper or sprayer may be arranged at a higher position than a position at which the silicon substrate is arranged or guided through the second etchant applicator. Accordingly, second etching solution may come from such higher position and may then be deposited on the first side forming an upper side of the silicon substrate using gravity.

Furthermore, the second etchant applicator may comprise a reservoir for accommodating the non-etching liquid, the reservoir being arranged at a lower side with regards to a position of the silicon substrate. Accordingly, non-etching liquid may be transferred from such lower reservoir to the second side forming a lower side of the silicon substrate. For example, the reservoir may be a basin or tank in which the non-etching liquid is accommodated.

According to an embodiment, the second etching solution is applied on top of the first side of the silicon substrate upon initially having a substantially lower temperature than a temperature the non-etching liquid has upon being brought into contact with the second side of the silicon substrate.

In other words, the second etchant applicator may be configured such that the second etching solution may be applied with a temperature which differs from the temperature of the non-etching liquid. For example, the dispenser, flusher, dripper or sprayer used for applying the second etching solution may comprise a thermaliser such as a heater and/or a cooler in order to bring the second etching solution to an elevated or reduced first temperature, respectively, in a predefined first temperature range. Similarly, the reservoir and/or any means for applying the non-etching liquid from the reservoir to the silicon substrate may comprise a thermaliser such as a heater and/or a cooler in order to bring the non-etching liquid to an elevated or reduced second temperature, respectively, in a predefined second temperature range. Therein, the first and second temperature ranges, or the first temperature of the second etching solution and the second temperature of the non-etching liquid, may differ from each other, for example by more than 10°C, more than 20°C or even more than 40°C.

For example, the second etching solution may initially be applied to the first side of the silicon substrate with the first temperature of for example less than 70°C, preferably less than 60°C or less than 40°C or the first temperature may correspond to an environmental temperature of e.g. between 10°C and 30°C. In contrast hereto, the non-etching liquid may be applied to the second side of the silicon substrate with the second temperature of for example more than 60°C or more than 70°C, preferably more than 80°C or even more than 90°C. Accordingly, as both opposite sides of the silicon substrate are contacted with liquid having substantially different first and second temperatures, a flow of thermal energy will occur throughout the silicon substrate. Thereby, the cooler first side of the silicon substrate and the second etching solution contacting this first side will be successively heated up by the hot non-etching liquid contacting the opposite second side of the silicon substrate. In other words, by bringing the hotter non-etching liquid in contact with the second side of the silicon substrate, the initially cooler second etching solution on top of the first side of the silicon substrate may be heated to an elevated temperature. Therein, as only a relatively small volume of second etching solution is applied to the first side of the silicon substrate whereas the second side is in thermal contact with a large volume of hot non-etching liquid in the reservoir, the final elevated temperature of the second etching solution will be close to the temperature of the hot non-etching liquid.

Accordingly, while the second etching solution initially being at the lower temperature may have a low etching activity, this etching activity may successively increase by heating the second etching solution to the higher temperature being close to the temperature of the non-etching liquid.

According to an embodiment, the second etching solution is applied on top of the first side of the silicon substrate before bringing the non-etching liquid into contact with the second side of the silicon substrate. In other words, the second etching solution is applied to the silicon substrate first, and only in a subsequent second step, the non-etching liquid is brought into contact with the silicon substrate on its opposite side. Thereby, the second etching solution may reach the first side of the silicon substrate while e.g. being at its initial lower first temperature and may subsequently be heated to an elevated temperature when the hotter non-etching liquid contacts the second side of the silicon substrate. Thus, the etching activity of the second etching solution may initially be low and may then increase together with the increasing temperature of the second etching solution, i.e. as a result of indirect heating through the hot non-etching liquid.

Particularly, according to an embodiment, the second etching solution is applied on top of the first side of the silicon substrate such that the second etching solution forms a film wetting the entire first side of the silicon substrate before bringing the non-etching liquid into contact with the second side of the silicon substrate. Expressed differently, the second etching solution may be applied to the first side of the silicon substrate in such a way and such a time interval before the non-etching liquid contacts the opposite side of the silicon substrate, such that the second etching solution may spread or be distributed along the first side of the silicon substrate, until it is wetting the entire first side, i.e. forms a continuous film on top of the first side. Only at a later point in time, when the first side is completely wetted by the second etching solution, the non-etching liquid is applied to the second side and thereby heats the film of the second etching solution covering the first side to an elevated temperature, at which it reaches substantial etching activity.

Due to such approach, inhomogeneous etching action may substantially be prevented. Such inhomogeneous etching action may otherwise occur, when the second etching solution would have or would reach substantial etching activity before covering the entire first side of the silicon substrate, i.e. when the second etching solution would already contact partial areas of the first side before reaching other areas of the first side of the silicon substrate while already having substantial etching activity.

According to an embodiment, the non-etching liquid may be brought into contact with the second side of the silicon substrate using one or more rollers which, with an upper part, contact the second side of the silicon substrate and which, with a lower part, dip into a reservoir comprising the non-etching liquid. For the wet bench proposed herein, this means that the second etchant applicator may comprise one or more rollers which are arranged and configured such as to, with an upper part, contact the second side of the silicon substrate and, with a lower part, dip into a reservoir comprising the non-etching liquid.

In other words, in order to bring the non-etching liquid into contact with the silicon substrate, one or more rollers may be provided. Such rollers may be configured and arranged such that they may transfer the non-etching liquid accommodated in a reservoir towards the second side of the silicon substrate. Accordingly, a roller may be at least partially submerged into the non-etching liquid comprised in the reservoir while being in contact with the silicon substrate with a non-submerged portion of the roller. Thereby, non-etching liquid may accumulate at the roller such that, when the silicon substrate rolls along the roller and thereby rotates the roller, this non-etching liquid is transferred to its lower, second side. The roller or rollers may convey and/or guide the silicon substrates along a transportation path. For example, the roller may have a porous and/or sponge-like circumferential surface such that the non-etching liquid may be temporarily absorbed and then transferred to the silicon substrate. Alternatively or additionally, the roller may have a surface texture including for example ribs such that non-etching liquid may be "shovelled" from the reservoir to the second side of the silicon substrate upon the silicon substrate being conveyed by the rotating roller.

According to an embodiment, the non-etching liquid may comprise a pH value of less than 7.0, i.e. the non-etching liquid may be at least slightly acidic. For example, an acid may be mixed into a neutral solvent such as water in order to lower its pH value. Such acid may be any acid which does not substantially attack the silicon substrate or any other exposed layers provided on its second side. For example, the non-etching liquid may have a pH value in a range of 2 - 6.5. For reducing the pH value, an acid such as e.g. HCl may be added to the non-etching liquid.

Having such acidic pH value, the non-etching liquid may serve as a neutralizing solution. This means that even in cases where minor amounts of alkaline second etching solution would be introduced into the reservoir with the non-etching liquid, such alkaline solution would be substantially neutralised. According to an embodiment, the proposed method may comprise an additional method step of removing the silicate glass layer on the second side of the silicon substrate by contacting the silicate glass layer on the second side with a third etching solution, the third etching solution etching silicate glass and not substantially etching silicon.

In other words, after having removed the emitter layer on the first side of the silicon substrate during the preceding second method step of back-etching the silicon in the second etching solution, the silicate glass layer which previously remained on the second side may then be removed.

Generally, such silicate glass layer should be removed before other processing steps in a solar cell production method are performed as such silicate glass layer may otherwise negatively influence such following processing steps. For example, the silicate glass layer should be removed before any other dielectric layer such as an antireflection layer or a passivation layer is deposited on the emitter layer at the second side.

For removing this silicate glass layer, it may be brought into contact with a third etching solution having same or similar characteristics as the first etching solution. Particularly, the third etching solution may be free from any oxidising chemicals, particularly the third etching solution may be free from nitric acid. For example, the third etching solution may comprise HF. Accordingly, the third etching solution may reliably and selectively etch-away the silicate glass layer on the second side but not attack the emitter layer underneath this silicate glass layer.

The final product of the first, second and third method steps is therefore generally a silicon substrate having an emitter layer only at its second side and having all silicate glass layers removed.

For implementing the third method step, the wet bench proposed herein may additionally comprise a third etchant applicator for accommodating a third etching solution and applying the third etching solution to the silicon substrate, the third etching solution etching silicate glass and not substantially etching silicon. Therein, the transportation mechanism is configured for transporting the silicon substrate along the transportation path including transporting the silicon substrate from the second etchant applicator to the third etchant applicator before finally transporting the silicon substrate to the exit area.

In other words, additionally to the first and second etchant applicators, the wet bench may comprise a third etchant applicator which is specifically configured for applying the third etching solution to the silicon substrate. Accordingly, the transportation path generated by the transportation mechanism also extends along this third etchant applicator.

However, contrary to the first etchant applicator, the third etchant applicator does not necessarily have to ensure that the third etching solution is applied exclusively to one side of the silicon substrate. Instead, as at this third step, all remaining silicate glass shall be removed from the silicon substrate, the entire silicon substrate may be immersed in the third etching solution.

As an alternative, the third etching solution may be applied using other application techniques. For example, the third etching solution may be applied using one or more sprayers and/or one or more rollers for supplying the third etching solution exclusively to the second side of the silicon substrate or to both opposite sides of the silicon substrate.

Accordingly, the third etchant applicator may comprise an etching solution reservoir and the transportation mechanism may be configured for immersing the silicon substrate in the etching solution reservoir.

Optionally, the third etching solution may further comprise hydrochloric acid (HCl). Such hydrochloric acid may be included in the third etching solution for cleaning purposes, particularly for removing metal residuals. The hydrochloric acid may be added in a concentration in a range of between 0.5 wt% and 10 wt%.

According to an embodiment, the proposed method may further comprise generating a thin silicon oxide (SiO₂) layer at a surface at at least one side of the silicon substrate. Such thin layer of silicon oxide may be required or be beneficial in some solar cell concepts such as for example a concept frequently referred to as TOPCon solar cell or high efficiency solar cells with passivated contacts. The thin silicon oxide may serve for passivating an underlying surface of the silicon substrate.

Preferably, the thin SiO₂ layer may be generated with a thickness of between 0.2 nm and 5 nm, more preferably with a thickness of between 0.5 nm and 3 nm or even more preferably with a thickness of between 1.2 nm and 1.6 nm. On the one hand, such very thin silicon oxide layer may serve as a highly passivating layer. On the other hand, such very thin silicon oxide layer may serve as a tunnel oxide through which charge carriers may be transmitted by tunnelling.

Accordingly, the very thin silicon oxide layer may be part of a highly passivated contact for electrically contacting the silicon substrate.

For example, the thin SiO₂ layer may be generated by applying an oxidising agent at the surface at the at least one side of the silicon substrate. The oxidising agent may be a chemical component which, when coming into contact with silicon, oxidises the silicon at a surface thereof. For example, such oxidising agent may be ozonised water (sometimes referred to as DIO₃), hydrogen peroxide (H₂O₂), nitric acid (HNO₃) or other wet-chemical solutions comprising deionised water together with at least one of nitric acid and hydrogen peroxide. Such wet-chemical approach for generating the thin silicon oxide layer may be easy and cheap to implement.

Finally, at the end of the entire method sequence comprising the first and second etching steps and optionally comprising the third etching step and/or other steps such as cleaning with hydrochloric acid and/or generating a thin silicon oxide layer, the silicon substrate may be rinsed and/or finally dried. Such rinsing and/or drying procedures may additionally also be implemented between other processing steps such as e.g. between some or each of the first, second and third etching steps. For such purpose, the wet bench may further comprise one or more rinsing units and a drying units.

It shall be noted that possible features and advantages of embodiments of the invention are described herein partly with respect to a method for selectively removing an emitter layer on a single side of the silicon substrate and partly with respect to a wet bench configured for implementing such method. One skilled in the art will recognize that the features may be suitably transferred from one embodiment to another and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawing. However, neither the drawing nor the description shall be interpreted as limiting the invention.
Fig. 1 visualizes steps of a method and of a device for selectively removing an emitter layer on a single side of a silicon substrate according to an embodiment not part of the present invention.
Fig. 2 visualizes a portion of a second etchant applicator of a wet bench according to an embodiment of the present invention.

The figure is only schematic and not to scale. Same reference signs refer to same or similar features.

### DESCRIPTION OF ADVANTAGEOUS EMBODIMENTS

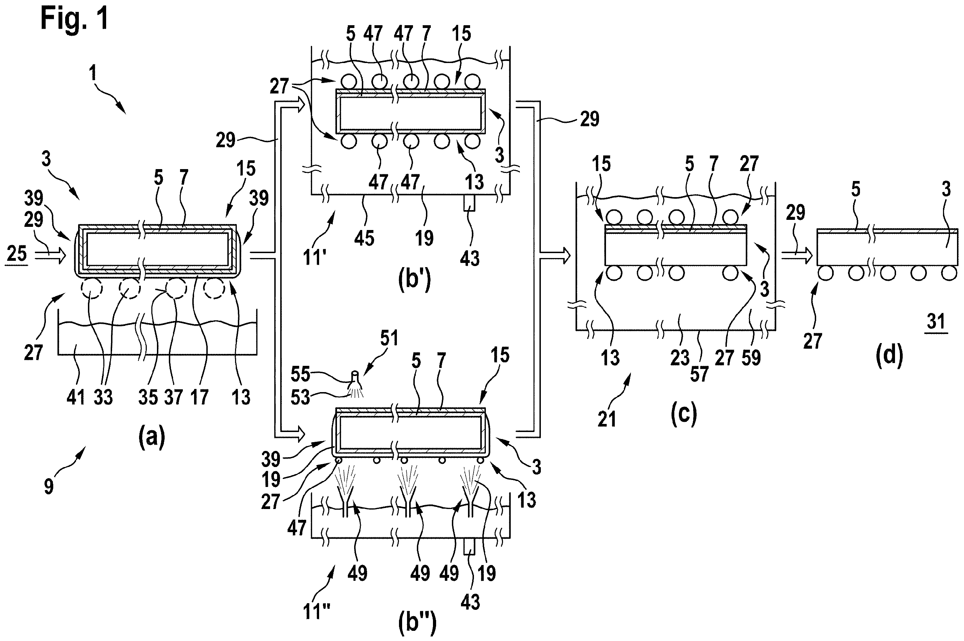

Fig. 1 schematically visualises various steps of a method and features of a wet bench 1 which may be applied upon for example producing a silicon solar cell for selectively removing an emitter layer from a single side of a silicon substrate 3.

In one or more preceding solar cell production steps, the silicon substrate 3 has been provided with a doped emitter layer 5 extending along its entire surface. Furthermore, as a result of such production steps, a silicate glass layer 7 is generated and covers the emitter layer 5 along its entire surface.

The method proposed herein comprises at least two separate etching steps which are executed in a sequence using separate etchant applicators 9, 11. In the first etching step, the silicate glass layer 7 is selectively removed on a first side 13 of the silicon substrate 3. In the example shown, this first side is a lower side of the silicon substrate 3. In the second etching step, the exposed emitter layer 5 on the first side 13 of the silicon substrate 3 is then removed. In the first and second etching steps, first and second etching solutions 17, 19 are applied using the first and second etchant applicators 9, 11.

Furthermore, the method comprises an additional third etching step in which the silicate glass layer 7 covering the second side 15 of the silicon substrate 3 is removed. For such purpose, the silicon substrate 3 is guided through a third etchant applicator 21 comprising a third etching solution 23.

In the wet bench 1, the silicon substrate 3 initially comprising both the emitter layer 5 and the silicate glass layer 7 at both of its opposing sides 13, 15 is introduced at an entry area 25 (only schematically represented). The silicon substrate 3 is then transferred through the wet bench 1 using a transportation mechanism 27 for transporting the silicon substrate 3 along a transportation path 29 ranging from the entry area 25 to the first etchant applicator 9, then to the second etchant applicator 11, then optionally to the third etchant applicator 21 and possibly to other processing stations before finally arriving at an exit area 31. The transportation mechanism 27 and the transportation path 29 are represented in Fig. 1 only very schematically. Various mechanical means including e.g. rollers, guiders, drivers, conveyor belts, endless units, etc. may be applied for transporting and guiding the silicon substrates 3 along the transportation path 29.

In the first etching step, the first etchant applicator 9 accommodates the first etching solution 17 in a reservoir 41 and applies the first etching solution 17 exclusively onto the first side 13 of the silicon substrate 3. For such purpose, the first etchant applicator 9 may comprise multiple rollers 33. Each of the rollers 33 may have a porous skin surface 35 having multiple openings 37. The first etching solution 17 may be introduced into the rollers 33 and may exit each of the rollers 33 through the openings 37 at their porous skin surfaces 35. The first side 13 of the silicon substrate 3 may be supported by the rollers 33. Accordingly, the rollers 33 may be part of the transportation mechanism 27. Alternatively, the silicon substrates 3 may be guided by other transportation means forming part of the transportation mechanism 27 such that the first side 13 of the silicon substrates 3 is transported along the skin surface 35 of the rollers 33.

Accordingly, using such first etchant applicator 9, the first etching solution 17 is applied exclusively to the lower first side 13 of the silicon substrate 3. Such first side 13 may include edges 39 or flanks of the silicon substrate 3 to which the first etching solution 17 may also be applied for example due to adhesion forces or capillary forces.

The first etchant applicator 9 may be embodied in various ways for example with regard to its reservoir 41, its rollers 33, conduits for supplying the first etching solution 17 to the rollers 33, mechanical support and/or guidance for the silicon substrate 3, etc. Details are not shown in the figure.

The first etching solution 17 is provided with a chemical composition such that it etches the silicate glass layer 7 but does not substantially etch the silicon forming, inter-alia, the emitter layer 5. Particularly, the first etching solution 17 may comprise hydrofluoric acid and may be free from any oxidising chemicals such as nitric acid.

After having completed the first etching step shown in Fig. 1(a), the silicon substrate 3 is freed from the silicate glass layer 7 covering its first side 13 such that the emitter layer 5 is exposed at this first side 13.

The silicon substrate 3 is then further moved along the transportation path 29 towards the second etchant applicator 11 for applying the second etching step, as shown in Fig. 1(b).

In this second etching step, the emitter layer 5 on the first side 13 is removed by contacting this emitter layer 5 with the second etching solution 19. This second etching solution 19 has an etching characteristics opposite to the etching characteristics of the first etching solution 17. This means that the second etching solution 19 is etching silicon but does not substantially etch silicate glass. For example, the second etching solution may be based on potassium hydroxide, sodium hydroxide or tetramethylammonium hydroxide.

In order to increase an etching rate of such second etching solution 19, the second etchant applicator 11 may comprise a heater 43 for heating the second etching solution 19 to temperatures of for example between 70°C and 100°C.

Furthermore, the second etching solution 19 may comprise an additive for increasing its etching selectivity characteristics. The second etchant applicator 11 may have an additive supplier (not shown) for supplying and/or metering the additive to the second etching solution 19.

Two different examples of a second etchant applicator 11', 11" are shown in Fig. 1(b). The transportation path 29 may run along one of such exemplary second etchant applicator 11', 11".

Fig. 1(b') shows an exemplary embodiment in which the second etchant applicator 11' comprises a basin 45 accommodating the second etching solution 19. The silicon substrate 3 is immersed into this basin 45 such that the second etching solution 19 contacts both of its first and second sides 13, 15. For example, the silicon substrate 3 may be guided by guiding rollers 47 or similar guiding means. A possible option for a transport apparatus, apparatus for handling an article and transport method is described in WO 2016/066838 A1 previously filed by the applicant.

In such exemplary embodiment, the silicate glass layer 7 covering the second side 15 of the silicon substrate 3 serves as a protection layer for the emitter layer 5 on this second side 15. Accordingly, the second solution 19 may attack the emitter layer 5 only at the exposed first side 13. Thus, in the second etching step, the emitter layer 5 may be etched-back selectively at the first side 13.

However, in scenarios or in solar cell concepts in which the silicate glass layer 7 covering the second side 15 of the silicon substrate 3 has been modified or damaged in preceding manufacturing steps for example due to irradiation of a laser beam and in which the silicate glass layer 7 may therefore no more act as a reliable protection layer, the silicon substrate 3 should not be immersed entirely into the second etching solution 19 and, particularly, the second etching solution 19 should not contact the silicate glass layer 7 at the second side 15 of the silicon substrate 3.

Accordingly, in the exemplary embodiment shown in Fig. 1(b"), the second etching solution 19 is selectively sprayed only onto the first side 13 of the silicon substrate 3. For such purpose, the second etchant applicator 11" comprises one or more sprayers 49. These sprayers 49 may spray a film of second etching solution 19 from underneath the silicon substrate 3 onto the lower first side 13. Due to adhesion forces or capillary forces, this film may also extend towards the edges 39 of the silicon substrate 3.

The sprayers 49 may spray the second etching solution 19 directly onto the first side 13. Alternatively, for example in order to restrict distribution of the second etching solution 19 and avoid that the second etching solution 19 reaches the upper second side 15 of the silicon substrate 3, a fleece, tissue or similar means may be provided in between the sprayers 49 and the silicon substrates 3 (not shown). Such fleece, tissue or similar means may be arranged such that it mechanically contacts the first side 13 of the silicon substrate 3. The second etching solution 19 may be sprayed onto this fleece, tissue or similar means such that it is absorbed and distributed homogeneously along the fleece, tissue or similar means. Optionally, the fleece, tissue or similar means may mechanically support the silicon substrate 3 and may be moved in order to transport the silicon substrate 3 resting onto the fleece, tissue or similar means along the transportation path 29 at the second etchant applicator 11". Optionally, the second etchant applicator 11" may comprise means for cleaning, treating and/or recycling the fleece, tissue or similar means.

Optionally, the second etchant applicator 11" may additionally include a coolant applicator 51. The coolant applicator 51 may apply a cooling solution 53 to the second side 15 of the silicon substrate 3 while or before the second etching solution 19 is applied to the opposite first side 13. In the example shown, the coolant applicator 51 may comprise a nozzle 55 which may spray or drip the coolant solution 53 onto the second side 15 of the silicon substrate 3. Accordingly, due to the temperature of the cooling solution 53 being substantially lower than the temperature of the second etching solution 19, this cooling solution 53 may hinder any second etching solution 19 reaching the upper second side 15 from significantly etching the emitter layer 5 at this second side 15. For example, the cooling solution 53 may have the same chemical composition as the second etching solution 19, but is at a substantially lower temperature.

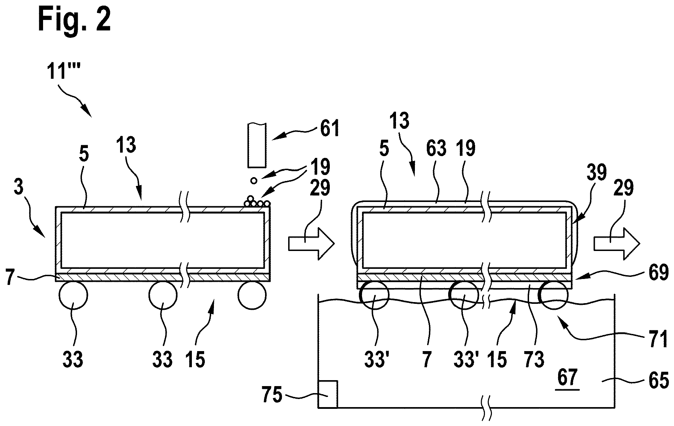

Fig. 2 visualises a second etchant applicator 11‴ of a wet bench according to another exemplary embodiment. Therein, the second etchant applicator 11"' is adapted for removing the emitter layer 5 while the silicon substrate 3 is arranged in a sunny side down configuration with its first side 13 directing in an upwards direction.

In such approach, the silicon substrate 3 is transported using various rollers 33, 33'. Using a dispenser 61 or any similar means, the second etching solution 19 is applied on top of the first side 13 of the silicon substrate 3 while the silicon substrate 3 passes underneath the dispenser 61. Thereby, a continuous film 63 of second etching solution 19 is formed such as to cover and wet the first side 13 of the silicon substrate 3. Preferably, the film 63 is generated such that it also covers circumferential edges 39 of the silicon substrate 3. The film 63 of second etching solution 19 is formed before the silicon substrate 3 reaches a second stage of the second etchant applicator 11‴.

In such second stage, a reservoir 65 is arranged underneath the transportation path 29 along which the silicon substrates 3 are continuously transferred. Such reservoir 65 accommodates a non-etching liquid 67 such as water, possibly including minor contributions of an acid for reducing its pH value. In the second stage, rollers 33' are arranged such that an upper part 69 of a roller 33'contacts the second side 15 of the silicon substrate 3 while a lower part 71 of the same roller 33'dips into the non-etching liquid 67 comprised in the reservoir 65. The rollers 33' are provided for example with a porous or textured surface such as, upon being rotated when silicon substrates 3 are to be transported, transferring or shovelling portions of the non-etching liquid 67 towards the second side 15 of the silicon substrate 3. Thereby, a continuous film 73 of nonetchant liquid 67 is formed, this continuous film 73 covering the entire second side 15 of the silicon substrate 3. Accordingly, the continuous film 73 protects the second side 15 and the silicate glass layer 7 provided thereon against any attack from being contacted with second etching solution 19, as such second etching solution 19 being present on the upper first side 13 of the silicon substrate 5 is prevented from reaching the lower second side 15 of the silicon substrate 5.

Furthermore, the non-etching liquid 67 may be heated to an elevated temperature using for example a heater 75 included in the reservoir 65. For example, the non-etching liquid 67 may be heated to a temperature of between 70°C and 100°C. Upon being transferred to the second side 15 of the silicon substrate, heat is transferred to the silicon substrate 3 such that the film 63 of second etching solution 19 covering the upper first side 13 of the silicon substrate 3, which has previously been dispensed by the dispenser 61 at a lower temperature such as room temperature onto the first side 13, is successively heated to an elevated temperature. Due to such elevated temperature, an etching activity of the second etching solution 19 increases. Accordingly, with the film 63 of the second etching solution 19 covering the entire first side 13 plus, optionally, the circumferential edges 39, the emitter layer 5 of the silicon substrate 3 may selectively be etched and removed from such areas of the silicon substrate 3 during the second etching step.

After completion of the second etching step, the silicon substrate 3 is freed at its first side 13 from both, the silicate glass layer 7 as well as the emitter 5. However, at the opposite second side 15, the silicon substrate 3 still comprises both the emitter layer 5 and the covering silicate glass layer 7. This is visualised in Fig. 1(c).

In order to remove the silicate glass layer 7 also at the second side 15, the silicon substrate 3 may be submitted to a third etching step using the third etchant applicator 21, as shown in Fig. 1(c). In the example shown, the third etchant applicator 21 comprises another basin 57 forming an etching solution reservoir 59. A third etching solution 23 is accommodated in this basin 57. This third etching solution 23 may be similar or same to the first etching solution 17. Particularly, the third etching solution 23 may comprise hydrofluoric acid and may be free of oxidising chemicals such as nitric acid. Additionally, the third etching solution 23 may comprise hydrochloric acid. As this third etching solution 23 selectively etches silicate glass but does not substantially etch silicon, the silicate glass layer 7 on top of the second surface 15 is removed from the silicon substrate 3 whereas the emitter layer 5 on the second surface 15 is not attacked.

Subsequent to the third etching step, further optional processing steps may be applied. For example a thin silicon oxide layer may be generated on the outer surface of the silicon substrate 3 for example by applying an oxidising agent to this outer surface. For such purpose, an oxidising agent applicator (not shown) may be provided in the wet bench 1.

Finally, the silicon substrate 3 may be rinsed and dried in a rinsing unit and a drying unit (not shown) before exiting the wet bench 1 at the exiting area 31.

Overall, embodiments of the method and the wet bench 1 described herein may provide for various benefits. For example, operation costs for a single sided removal of an emitter layer 5 may be reduced. Damages at the second side 15 may be avoided during the second etching step as, at least in one embodiment, no second etching solution is sprayed onto this second side 15. The method may allow increased etching rates thereby enabling fast production cycles. Furthermore, compared to standard etching using a composition of hydrofluoric acid and nitric acid, the use of a two-step etching sequence with the second etching step using an alkaline base as second etching solution 19 may allow for a smoother and/or more planar etched surface of the silicon substrate 3. In the method proposed herein, etching solution may be applied which may be relatively easy to recycle, to reprocess and/or to dispose. Furthermore, less toxic chemicals may be applied, thereby possibly reducing the safety requirements to be fulfilled. Furthermore, no or less toxic gases may be produced in the method proposed herein compared to conventional standard processes in which for example nitrogen oxides (NOₓ) or nitrous fumes may be produced. Additionally, no or fewer amounts of aggressive gases possibly attacking the emitter layer are generated.

Specifically, by replacing, in an emitter removal process, a conventional single step etching procedure based on an etching composition comprising HF and HNO₃ by a two-step sequence using e.g. a HNO₃-free and/or NOₓ-free HF-based first etching solution (17) and e.g. an alkaline base as the second etching solution (19), various benefits may be realised.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### list of reference numerals

- 1: wet bench
- 3: silicon substrate
- 5: emitter layer
- 7: silicate glass layer
- 9: first etchant applicator
- 11: second etchant applicator
- 13: first side of the silicon substrate
- 15: second side of the silicon substrate
- 17: first etching solution
- 19: second etching solution
- 21: third etchant applicator
- 23: third etching solution
- 25: entry area
- 27: transportation mechanism
- 29: transportation path
- 31: exit area
- 33: roller
- 35: skin surface
- 37: openings
- 39: edges of the silicon substrate
- 41: reservoir for the first etching solution
- 43: heater
- 45: basin
- 47: guiding roller
- 49: sprayer
- 51: coolant applicator
- 53: cooling solution
- 55: nozzle
- 57: basin
- 59: etching solution reservoir
- 61: dispenser
- 63: continuous film of second etching solution
- 65: reservoir
- 67: non-etching liquid
- 69: upper part of roller
- 71: lower part of roller
- 73: continuous film of non-etching liquid
- 75: heater

## Claims

1. Method for selectively removing an emitter layer (5) on a single side (13) of a silicon substrate (3), wherein the silicon substrate (3) initially comprises an emitter layer (5) at both opposing sides (13, 15) and wherein the silicon substrate (3) initially comprises a silicate glass layer (7) covering the emitter layer (5) at both opposing sides (13, 15), wherein the method comprises:
- selectively removing the silicate glass layer (7) exclusively on a first side (13) of a silicon substrate (3) by contacting the silicate glass layer (7) exclusively on the first side (13) with a first etching solution (17), the first etching solution (17) etching silicate glass and not substantially etching silicon; and
- removing the emitter layer (5) on the first side (13) of a silicon substrate (3) by contacting the emitter layer (5) on the first side (13) with a second etching solution (19), the second etching solution (19) etching silicon and not substantially etching silicate glass,
wherein, in the step of removing the emitter layer (5), the silicon substrate (3) is arranged with its first side (13) directed in an upwards direction,
wherein the second etching solution (19) is applied on top of the first side (13) of the silicon substrate (3) and
wherein, in the step of removing the emitter layer (5), a non-etching liquid (67) is brought into contact with the second side (15) of the silicon substrate (3).

2. Method of claim 1, wherein the second etching solution (19) is applied on top of the first side (13) of the silicon substrate (3) with initially having a substantially lower temperature than a temperature the non-etching liquid (67) has upon being brought into contact with the second side (15) of the silicon substrate (3).

3. Method of one of claims 1 and 2, wherein the second etching solution (19) is applied on top of the first side (13) of the silicon substrate (3) before bringing the non-etching liquid (67) into contact with the second side (15) of the silicon substrate (3).

4. Method of one of claims 1 to 3, wherein the second etching solution (19) is applied on top of the first side (13) of the silicon substrate (3) such that the second etching solution (19) forms a film (63) wetting the entire first side (13) of the silicon substrate (3) before bringing the non-etching liquid (67) into contact with the second side (15) of the silicon substrate (3).

5. Method of one of claims 1 to 4, wherein the non-etching liquid (67) is brought into contact with the second side (15) of the silicon substrate (3) using one or more rollers (33') which, with an upper part (69), contact the second side (15) of the silicon substrate (3) and which, with a lower part (71), dip into a reservoir (65) comprising the non-etching liquid (67).

6. Method of one of claims 1 to 5, wherein the non-etching liquid (67) comprises a pH value of less than 7.0.

7. Method of one of the preceding claims, wherein the second etching solution (19) is initially applied with a temperature of between 0°C and 60°C and is subsequently heated to an elevated temperature of between 40°C and 160°C.

8. Method of one of the preceding claims, wherein the second etching solution (19) comprises an additive, wherein the additive increases a selectivity of an etching action of the second etching solution (19) with respect to etching silicon compared to etching silicate glass.

9. Method of claim 8, wherein the second etching solution (19) comprises between 0.1 % and 30 % of the additive.

10. Method for fabricating a silicon solar cell, comprising:
- generating a doped emitter layer (5) in a silicon substrate (3) and a silicate glass layer (7) covering the emitter layer (5), the emitter layer (5) and the silicate glass layer (7) being generated by diffusing dopants from an atmosphere comprising the dopants and further comprising oxygen into a surface area at both sides (13, 15) of the silicon substrate (3);
- selectively removing the emitter layer (5) on a single side (13) of the silicon substrate (3) using the method according to one of the preceding claims.

11. Wet bench (1) comprising:
- a first etchant applicator (9) for accommodating a first etching solution (17) and applying the first etching solution (17) to a silicon substrate (3), the first etching solution (17) etching silicate glass and not substantially etching silicon,
- a second etchant applicator (11) for accommodating a second etching solution (19) and applying the second etching solution (19) to the silicon substrate (3), the second etching solution (19) etching silicon and not substantially etching silicate glass,
- a transportation mechanism (27) for transporting multiple silicon substrates (3) along a transportation path (29) ranging initially from an entry area (25) to the first etchant applicator (9), then to the second etchant applicator (11) and finally to an exit area (31),
wherein each of the first and second etchant applicator (9, 11) and the transportation mechanism (27) is configured such that the first and second etching solution (17, 19), respectively, is applied exclusively to a first side (13) of the silicon substrate (3),
wherein the wet bench is configured for implementing the method according to one of claims 1 to 9.

12. Wet bench of claim 11, wherein the second etchant applicator (11‴) comprises at least one of a dispenser (61), a flusher, a dripper and a sprayer configured for applying the second etching solution (19) on top of the first side (13) of the silicon substrate (3) upon the silicon substrate (3) being arranged with its first side (13) directed in an upwards direction.

13. Wet bench of one of claims 1 1 and 12, wherein the second etchant applicator (11‴) comprises a reservoir (65) for accommodating the non-etching liquid (67), the reservoir (65) being arranged at a lower side with regards to a position of the silicon substrate (3).

14. Wet bench of claim 13, wherein the reservoir (65) comprises a heater (75) for heating the non-etching liquid (67) to elevated temperatures.

15. Wet bench of one of claims 11 to 14, wherein the second etchant applicator (11‴) comprises one or more rollers (33') which are arranged and configured such as to, with an upper part (69), contact the second side (15) of the silicon substrate (3) and, with a lower part (71), dip into a reservoir (65) comprising the non-etching liquid (67).

## Patentansprüche

1. Verfahren zum selektiven Entfernen einer Emitterschicht (5) an einer einzigen Seite (13) eines Siliziumsubstrats (3), wobei das Siliziumsubstrat (3) anfänglich eine Emitterschicht (5) an beiden gegenüberliegenden Seiten (13, 15) aufweist und wobei das Siliziumsubstrat (3) anfänglich eine Silikatglasschicht (7) aufweist, die die Emitterschicht (5) an beiden entgegengesetzten Seiten (13, 15) bedeckt, wobei das Verfahren umfasst:
- selektives Entfernen der Silikatglasschicht (7) ausschließlich an einer ersten Seite (13) eines Siliziumsubstrats (3) durch Inkontaktbringen der Silikatglasschicht (7) ausschließlich an der ersten Seite (13) mit einer ersten Ätzlösung (17), wobei die erste Ätzlösung (17) Silikatglas ätzt und Silizium nicht wesentlich ätzt; und
- Entfernen der Emitterschicht (5) an der ersten Seite (13) eines Siliziumsubstrats (3) durch Inkontaktbringen der Emitterschicht (5) an der ersten Seite (13) mit einer zweiten Ätzlösung (19), wobei die zweite Ätzlösung (19) Silizium ätzt und Silikatglas nicht wesentlich ätzt,
wobei in dem Schritt des Entfernens der Emitterschicht (5) das Siliziumsubstrat (3) mit seiner ersten Seite (13) nach oben gerichtet angeordnet ist,
wobei die zweite Ätzlösung (19) auf die erste Seite (13) des Siliziumsubstrats (3) aufgebracht wird und
wobei, im Schritt des Entfernens der Emitterschicht (5), eine nicht-ätzende Flüssigkeit (67) mit der zweiten Seite (15) des Siliziumsubstrats (3) in Kontakt gebracht wird.

2. Verfahren nach Anspruch 1, wobei die zweite Ätzlösung (19) auf die erste Seite (13) des Siliziumsubstrats (3) aufgebracht wird, wobei sie anfänglich eine wesentlich niedrigere Temperatur hat als eine Temperatur, die die nicht-ätzende Flüssigkeit (67) hat, wenn sie mit der zweiten Seite (15) des Siliziumsubstrats (3) in Kontakt gebracht wird.

3. Verfahren nach einem der Ansprüche 1 und 2, wobei die zweite Ätzlösung (19) auf die erste Seite (13) des Siliziumsubstrats (3) aufgebracht wird, bevor die nicht-ätzende Flüssigkeit (67) mit der zweiten Seite (15) des Siliziumsubstrats (3) in Kontakt gebracht wird.

4. Verfahren nach einem der Ansprüche 1 bis 3, wobei die zweite Ätzlösung (19) auf die erste Seite (13) des Siliziumsubstrats (3) aufgebracht wird, so dass die zweite Ätzlösung (19) einen Film (63) bildet, der die gesamte erste Seite (13) des Siliziumsubstrats (3) benetzt, bevor die nicht-ätzende Flüssigkeit (67) mit der zweiten Seite (15) des Siliziumsubstrats (3) in Kontakt gebracht wird.

5. Verfahren nach einem der Ansprüche 1 bis 4, wobei die nicht-ätzende Flüssigkeit (67) mit der zweiten Seite (15) des Siliziumsubstrats (3) unter Verwendung einer oder mehrerer Walzen (33') in Kontakt gebracht wird, die mit einem oberen Teil (69) die zweite Seite (15) des Siliziumsubstrats (3) berühren und die mit einem unteren Teil (71) in ein Reservoir (65) eintauchen, das die nicht-ätzende Flüssigkeit (67) enthält.

6. Verfahren nach einem der Ansprüche 1 bis 5, wobei die nicht-ätzende Flüssigkeit (67) einen pH-Wert von weniger als 7,0 aufweist.

7. Verfahren nach einem der vorhergehenden Ansprüche, wobei die zweite Ätzlösung (19) anfänglich mit einer Temperatur von zwischen 0°C und 60°C aufgebracht und anschließend auf eine erhöhte Temperatur von zwischen 40°C und 160°C erwärmt wird.

8. Verfahren nach einem der vorhergehenden Ansprüche, wobei die zweite Ätzlösung (19) ein Additiv umfasst, wobei das Additiv eine Selektivität einer Ätzwirkung der zweiten Ätzlösung (19) in Bezug auf das Ätzen von Silizium im Vergleich zum Ätzen von Silikatglas erhöht.

9. Verfahren nach Anspruch 8, wobei die zweite Ätzlösung (19) zwischen 0,1 % und 30 % des Additivs enthält.

10. Verfahren zur Herstellung einer Silizium-Solarzelle, umfassend:
- Erzeugen einer dotierten Emitterschicht (5) in einem Siliziumsubstrat (3) und einer Silikatglasschicht (7), die die Emitterschicht (5) bedeckt, wobei die Emitterschicht (5) und die Silikatglasschicht (7) durch Diffundieren von Dotierstoffen aus einer Atmosphäre, die die Dotierstoffe und ferner Sauerstoff enthält, in einen Oberflächenbereich an beiden Seiten (13, 15) des Siliziumsubstrats (3) erzeugt werden;
- selektives Entfernen der Emitterschicht (5) auf einer einzigen Seite (13) des Siliziumsubstrats (3) nach dem Verfahren gemäß einem der vorhergehenden Ansprüche.

11. Nassbank (1) aufweisend:
- einen ersten Ätzmittelapplikator (9) zum Aufnehmen einer ersten Ätzlösung (17) und zum Aufbringen der ersten Ätzlösung (17) an ein Siliziumsubstrat (3), wobei die erste Ätzlösung (17) Silikatglas ätzt und Silizium nicht wesentlich ätzt,
- einen zweiten Ätzmittelapplikator (11) zum Aufnehmen einer zweiten Ätzlösung (19) und zum Aufbringen der zweiten Ätzlösung (19) an das Siliziumsubstrat (3), wobei die zweite Ätzlösung (19) Silizium ätzt und Silikatglas nicht wesentlich ätzt,
- einen Transportmechanismus (27) zum Transportieren mehrerer Siliziumsubstrate (3) entlang eines Transportweges (29), der zunächst von einem Eingangsbereich (25) zu dem ersten Ätzmittelapplikator (9), dann zu dem zweiten Ätzmittelapplikator (11) und schließlich zu einem Ausgangsbereich (31) verläuft,
wobei sowohl der erste als auch der zweite Ätzmittelapplikator (9, 11) und der Transportmechanismus (27) so konfiguriert sind, dass die erste bzw. zweite Ätzlösung (17, 19) ausschließlich an eine erste Seite (13) des Siliziumsubstrats (3) aufgebracht wird,
wobei die Nassbank zur Durchführung des Verfahrens nach einem der Ansprüche 1 bis 9 konfiguriert ist.

12. Nassbank nach Anspruch 11, wobei der zweite Ätzmittelapplikator (11‴) einen Spender (61), eine Spüleinrichtung, einen Tropfer und/oder einen Sprüher umfasst, die so konfiguriert sind, dass sie die zweite Ätzlösung (19) auf die erste Seite (13) des Siliziumsubstrats (3) auftragen, wenn das Siliziumsubstrat (3) mit seiner ersten Seite (13) in einer Aufwärtsrichtung angeordnet ist.

13. Nassbank nach einem der Ansprüche 11 und 12, wobei der zweite Ätzmittelapplikator (11‴) ein Reservoir (65) zur Aufnahme der nicht-ätzenden Flüssigkeit (67) aufweist, wobei das Reservoir (65) an einer unteren Seite in Bezug auf eine Position des Siliziumsubstrats (3) angeordnet ist.

14. Nassbank nach Anspruch 13, wobei das Reservoir (65) eine Heizung (75) zum Erwärmen der nicht-ätzenden Flüssigkeit (67) auf erhöhte Temperaturen umfasst.

15. Nassbank nach einem der Ansprüche 11 bis 14, wobei der zweite Ätzmittelapplikator (11‴) eine oder mehrere Walzen (33') umfasst, die so angeordnet und konfiguriert sind, dass sie mit einem oberen Teil (69) die zweite Seite (15) des Siliziumsubstrats (3) berühren und mit einem unteren Teil (71) in ein Reservoir (65) eintauchen, das die nicht-ätzende Flüssigkeit (67) enthält.

## Revendications

1. Procédé d'enlèvement sélectif d'une couche d'émetteur (5) sur un seul côté (13) d'un substrat de silicium (3), dans lequel le substrat de silicium (3) comprend initialement une couche d'émetteur (5) aux deux côtés opposés (13, 15) et le substrat de silicium (3) comprenant initialement une couche de verre de silicate (7) recouvrant la couche d'émetteur (5) aux deux côtés opposés (13, 15), le procédé comprenant :
- l'enlèvement sélectif de la couche de verre de silicate (7) exclusivement sur un premier côté (13) d'un substrat de silicium (3) par mise en contact de la couche de verre de silicate (7) exclusivement sur le premier côté (13) avec une première solution de gravure (17), la première solution de gravure (17) gravant le verre de silicate et ne gravant essentiellement pas le silicium ; et
- l'enlèvement de la couche d'émetteur (5) sur le premier côté (13) d'un substrat de silicium (3) par mise en contact de la couche d'émetteur (5) sur le premier côté (13) avec une seconde solution de gravure (19), la seconde solution de gravure (19) gravant le silicium et ne gravant essentiellement pas le verre de silicate,
dans lequel, dans l'étape d'enlèvement de la couche d'émetteur (5), le substrat de silicium (3) est disposé avec son premier côté (13) dirigé dans une direction vers le haut,
dans lequel la seconde solution de gravure (19) est appliquée sur la partie supérieure du premier côté (13) du substrat de silicium (3) et
dans lequel, dans l'étape d'enlèvement de la couche d'émetteur (5), un liquide de non gravure (67) est mis en contact avec le second côté (15) du substrat de silicium.

2. Procédé selon la revendication 1, dans lequel la seconde solution de gravure (19) est appliquée sur la partie supérieure du premier côté (13) du substrat de silicium (3) avec initialement ayant une température essentiellement inférieure à une température qu'a le liquide de non gravure (67) étant mis en contact avec le second côté (15) du substrat de silicium (3).

3. Procédé selon l'une des revendications 1 et 2, dans lequel la seconde solution de gravure (19) est appliquée sur la partie supérieure du premier côté (13) du substrat de silicium (3) avant de mettre en contact le liquide de non gravure (67) avec le second côté (15) du substrat de silicium (3).

4. Procédé selon l'une des revendications 1 à 3, dans lequel la seconde solution de gravure (19) est appliquée sur la partie supérieure du premier côté (13) du substrat de silicium (3) de telle manière que la seconde solution de gravure (19) forme un film (63) mouillant le premier côté entier (13) du substrat de silicium (3) avant de mettre le liquide de non gravure (67) en contact avec le second côté (15) du substrat de silicium (3).

5. Procédé selon l'une des revendications 1 à 4, dans lequel le liquide de non gravure (67) est mis en contact avec le second côté (15) du substrat de silicium (3) en utilisant un ou plusieurs rouleaux (33') qui, avec une partie supérieure (69), contacte le second côté (15) du substrat de silicium (3) et qui, avec une partie inférieure (71), plonge dans un réservoir (65) comprenant le liquide de non gravure (67).

6. Procédé selon l'une des revendications 1 à 5, dans lequel le liquide de non gravure (67) comprend une valeur de pH de moins de 7,0.

7. Procédé selon l'une des revendications précédentes, dans lequel la seconde solution de gravure (19) est initialement appliquée avec une température comprise entre 0 °C et 60 °C et est ensuite chauffée à une température élevée comprise entre 40 °C et 160 °C.

8. Procédé selon l'une des revendications précédentes, dans lequel la seconde solution de gravure (19) comprend un additif, dans lequel l'additif augmente une sélectivité d'une action de gravure de la seconde solution de gravure (19) par rapport à la gravure de silicium en comparaison de la gravure du verre de silicate.

9. Procédé selon la revendication 8, dans lequel la seconde solution de gravure (19) comprend entre 0,1 % et 30 % de l'additif.

10. Procédé de fabrication d'une cellule solaire de silicium, comprenant :
- la génération d'une couche d'émetteur dopée (5) dans un substrat de silicium (3) et une couche de verre de silicate (7) recouvrant la couche d'émetteur (5), la couche d'émetteur (5) et la couche de verre de silicate (7) étant générées par des dopants diffusant à partir d'une atmosphère comprenant les dopants et comprenant en outre de l'oxygène dans une surface aux deux côtés (13, 15) du substrat de silicium (3) ;
- l'enlèvement sélectif de la couche d'émetteur (5) sur un seul côté (13) du substrat de silicium (3) en utilisant le procédé selon l'une des revendications précédentes.

11. Banc humide (1) comprenant :
- un premier applicateur de graveur (9) pour loger une première solution de gravure (17) et appliquer la première solution de gravure (17) à un substrat de silicium (3), la première solution de gravure (17) gravant le verre de silicate et ne gravant essentiellement pas le silicium,
- un second applicateur de graveur (11) pour loger une seconde solution de gravure (19) et appliquer la seconde solution de gravure (19) au substrat de silicium (3), la seconde solution de gravure (19) gravant le silicium et ne gravant essentiellement pas le verre de silicate,
- un mécanisme de transport (27) pour transporter de multiples substrats de silicium (3) le long d'un chemin de transport (29) se situant initialement d'une surface d'entrée (25) au premier applicateur de graveur (9), puis au second applicateur de graveur (11) et finalement à une surface de sortie (31),
dans lequel chacun des premier et second applicateurs de graveur (9, 11) et le mécanisme de transport (27) sont configurés de telle manière que la première et la seconde solutions de gravure (17, 19), respectivement, sont appliquées exclusivement à un premier côté (13) du substrat de silicium (3),
dans lequel le banc humide est configuré pour mettre en œuvre le procédé selon l'une des revendications 1 à 9.

12. Banc humide selon la revendication 11, dans lequel le second applicateur de graveur (11''') comprend au moins un d'un distributeur (61), d'une chasse d'eau, d'un égouttoir et d'un pulvérisateur configurés pour appliquer la seconde solution de gravure (19) sur la partie supérieure du premier côté (13) du substrat de silicium (3) après que le substrat de silicium (3) ait été disposé avec son premier côté (13) dirigé dans une direction vers le haut.

13. Banc humide selon l'une des revendications 11 et 12, dans lequel le second applicateur de graveur (11''') comprend un réservoir (65) pour loger le liquide de non gravure (67), le réservoir (65) étant disposé à un côté inférieur par rapport à une position du substrat de silicium (3).

14. Banc humide selon la revendication (13), dans lequel le réservoir (65) comprend un appareil de chauffage (75) pour chauffer le liquide de non gravure (67) à des températures élevées.

15. Banc humide selon l'une des revendications 11 à 14, dans lequel le second applicateur de graveur (11''') comprend un ou plusieurs rouleaux (33') qui sont disposés et configurés de manière à, avec une partie supérieure (69), contacter le second côté (15) du substrat de silicium (3) et, avec une partie inférieure (71), plonger dans un réservoir (65) comprenant le liquide de non gravure (67).
